# EUROPEAN PATENT SPECIFICATION

(11) **EP 4 506 783 B1**
(45) Date of publication and mention of the grant of the patent: **18.02.2026**
(21) Application number: 24192960.3
(22) Date of filing: 05.08.2024
(51) Int. Cl.: G06F 1/20, F28D 15/02, H05K 7/20

(54) **HEAT DISSIPATION MODULE AND ELECTRONIC DEVICE INCLUDING THE SAME**
WÄRMEABLEITUNGSMODUL UND ELEKTRONISCHE VORRICHTUNG DAMIT
MODULE DE DISSIPATION DE CHALEUR ET DISPOSITIF ÉLECTRONIQUE LE COMPRENANT

(30) Priority: 07.08.2023 KR 20230103088
(43) Date of publication of application: 12.02.2025
(73) Proprietor: Samsung Display Co., Ltd., Gyeonggi-do 17113 (KR)
(72) Inventor: SON, Jun Hee, 17113 Yongin-si (KR); PARK, Haeng Won, 17113 Yongin-si (KR); OH, Hyun Joon, 17113 Yongin-si (KR); LEE, Jee Na, 17113 Yongin-si (KR)
(74) Representative: Walaski, Jan Filip

(56) References cited:
- WO-A1-2014/158481
- CN-A- 101 636 068
- US-A1- 2022 304 199

## Description

### CROSS-REFERENCE TO RELATED APPLICATION

The present application claims priority to Korean patent publication number KR20250022312A filed on August 7, 2023.

### BACKGROUND

### 1. Field of Inventive concept

The disclosure relates to a heat dissipation module and an electronic device including the heat dissipation module.

### 2. Description of Related Art

With the development of information technology, the importance of a display device, which is a connection medium between a user and information, has been emphasized. Owing to the importance of display devices, the use of various kinds of display devices, such as a liquid crystal display device and an organic light-emitting display device, has increased.

Electronic devices including display devices may generate heat during an operating process thereof. The heat generated during the operation of electronic devices can potentially degrade the performance of the electronic devices and, in some cases, shorten the lifespan of the electronic devices. Therefore, there is a need for solutions that can efficiently dissipate heat generated from the electronic devices. CN 101 636 068 A discloses a flat-plate water tank radiator.US 2022/0304199 A1 discloses a display module including a heat dissipation layer.

### SUMMARY

Various embodiments of the present disclosure are directed to a heat dissipation module with improved heat dissipation efficiency, and an electronic device including the heat dissipation module.

According to an aspect of the invention, there is provided a heat dissipation module as set out in claim 1. A heat dissipation module comprises: a first plate, a partition wall, coupled to the first plate and defining a first path having one side closed by the first plate, and a second path spaced apart from the first path and communicating with an outside of the heat dissipation module, the first path forming a closed loop; a working fluid disposed in the first path, and a second plate coupled to the partition wall with the partition wall disposed between the first plate and the second plate, wherein the second path is disposed between the partition wall and the second plate, wherein the second plate includes at least one hole that exposes at least a portion of the second path.

The first planar component may include a first surface, and the second planar component may include a second surface.

The partition wall may be disposed to be inclined with respect to the first surface and the second surface. The first path may have a width of a third dimension disposed adjacent to the first surface and may have a width of a fourth dimension less than the third dimension and disposed adjacent to the second surface. The second path may have a width of a fifth dimension adjacent to the first surface and may have a width of a sixth dimension greater than the fifth dimension and disposed adjacent to the second surface.

An inclined angle formed between the partition wall and the first surface in an area corresponding to the first path is an acute angle.

The partition wall may include at least two stepped portions. The first path may have a width of a seventh dimension disposed between the first surface and the second surface and the seventh dimension may be less than the third dimension and greater than the fourth dimension. The second path may have a width of an eighth dimension disposed between the first surface and the second surface and the eighth dimension may be greater than the fifth dimension and less than the sixth dimension.

The partition wall may include an opening in an area facing away from the first planar component and the opening may be used to communicate with the outside of the heat dissipation module.

The first path may have a width of a first dimension and the second path may have a width of a second dimension less than the first dimension.

The partition wall may include one or more stepped portions. The first path may have a width of a third dimension disposed adjacent to the first surface and may have a width of a fourth dimension less than the third dimension and disposed adjacent to the second surface. The second path may have a width of a fifth dimension disposed adjacent to the first surface and may have a width of a sixth dimension less than the fifth dimension and disposed adjacent to the second surface.

The working fluid may include liquid and an air layer.

The volume of the liquid in the working fluid may be 20% or more and less than 100%.

An embodiment may include an electronic device including: a display panel provided with a plurality of pixels arranged to display an image on a front surface of the display panel; and a heat dissipation module as defined above.

The electronic device may further include an adhesive component attached to the rear surface of the display panel, and configured to attach the rear surface of the display panel to the first planar component of the heat dissipation module.

### BRIEF DESCRIPTION OF THE DRAWINGS

FIG. 1 is a perspective view of an electronic device.
FIG. 2 is an exploded perspective view of the display device illustrated in FIG. 1.
FIG. 3 is a system block diagram of a display module.
FIG. 4 is an equivalent circuit diagram of a pixel.
FIG. 5 is a sectional view of the display panel including the pixel of FIG. 4.
FIG. 6 is a perspective view of a display module and a heat dissipation module.
FIG. 7 is a perspective sectional view of a heat dissipation module.
FIG. 8 is a sectional view illustrating area X in the heat dissipation module of FIG. 7.
FIG. 9 is a diagram for describing the heat dissipation module with liquid injected thereinto.
FIG. 10 is a rear perspective view of the heat dissipation module.
FIG. 11 is a diagram for describing performance of heat dissipation in the heat dissipation module.
FIG. 12 is a sectional view illustrating area X in another implementation of the heat dissipation module of FIG. 7.
FIG. 13 is a sectional view illustrating area X in another implementation of the heat dissipation module of FIG. 7.
FIG. 14 is a sectional view illustrating area X in another implementation of the heat dissipation module of FIG. 7.
FIG. 15 is a rear view of a heat dissipation module according to other implementations.

### DETAILED DESCRIPTION

Hereinafter, embodiments of the present inventive concept will be described in detail with reference to the attached drawings, such that those skilled in the art can easily implement the present inventive concept. The present disclosure may be implemented in various forms, and is not limited to the embodiments to be described below but are limited to the scope of the appended claims.

In the drawings, portions which are not related to the present disclosure may be omitted in order to explain the present disclosure more clearly. Reference should be made to the drawings, in which similar reference numerals are used throughout the different drawings to designate similar components. Therefore, the aforementioned reference numerals may be used in other drawings.

For reference, the size of each component and the thicknesses of lines illustrating the component are arbitrarily represented for the sake of explanation, and the present disclosure is not limited to what is illustrated in the drawings. In the drawings, the thicknesses of the components may be exaggerated to clearly depict multiple layers and areas.

Furthermore, the expression "being the same" may mean "being substantially the same". In other words, the expression "being the same" may include a range that can be tolerated by those skilled in the art. The other expressions may also be expressions from which "substantially" has been omitted.

It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element. In the present disclosure, the singular forms are intended to include the plural forms as well, unless the context clearly indicates otherwise.

The terms "under", "below", "above", "upper", and the like are used herein for explaining relationship between one or more components illustrated in the drawings. These terms may be relative terms describing the positions of components in the drawings, but the positions of components are not limited thereto.

Unless otherwise defined, all terms (including technical and scientific terms) used herein have the same meaning as commonly understood by one of ordinary skill in the art to which this inventive concept belongs. Furthermore, terms as defined in a commonly used dictionary should be construed as having the same meaning as in an associated technical context, unless defined apparently in the description, and the terms are not ideally or excessively construed as having formal meaning.

It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof.

Embodiments of the present disclosure will hereinafter be described in detail with reference to the accompanying drawings. In the following description, although numerous features may be designated as optional, it is nevertheless acknowledged that all features defined by claim 1 are not to be read as optional.

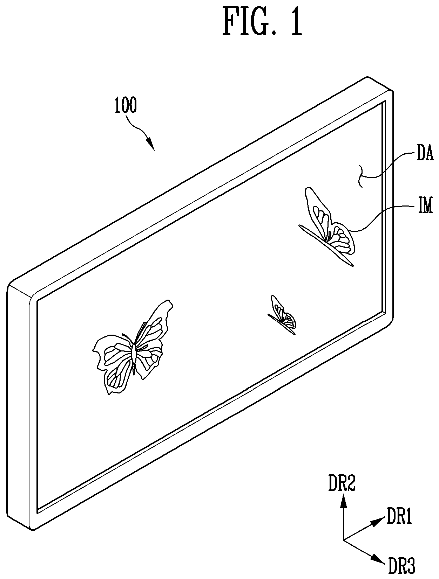

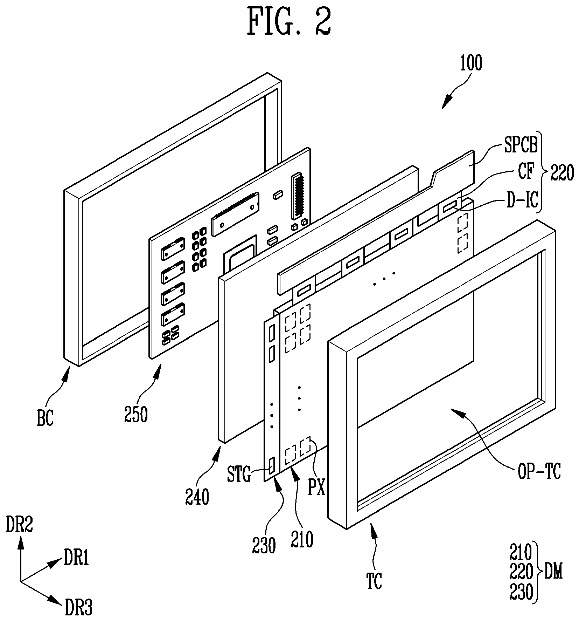

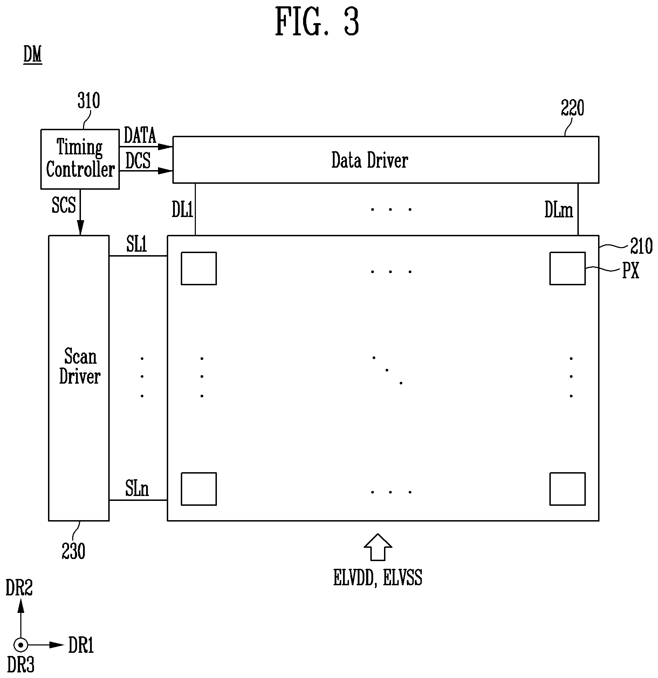

FIG. 1 is a perspective view of an electronic device 100. FIG. 2 is an exploded perspective view of the electronic device 100 illustrated in FIG. 1. FIG. 3 is a system block diagram of a display module DM.

The electronic device 100 may include a top cover TC, a display panel 210, a data driver 220, a scan driver 230, a heat dissipation module 240, a driving circuit substrate 250 and a bottom cover BC.

The bottom cover BC, the driving circuit substrate 250, the heat dissipation module 240, the display panel 210, and the top cover TC may overlap each other in one direction (e.g., a third direction DR3).

The display panel 210, the data driver 220, and the scan driver 230 may form the display module DM. At least some components (e.g., the timing controller 310) disposed on the driving circuit substrate 250 may be part of the display module DM.

The electronic device 100 may provide information about an image IM to a user of the electronic device 100 through the display area DA. As an example of the image IM, a butterfly is illustrated.

The top cover TC may be configured to protect the display panel 210. The top cover TC may include a cover opening OP-TC. The cover opening OP-TC exposes a front surface of the display panel 210, thus allowing the display area DA to be exposed to the outside.

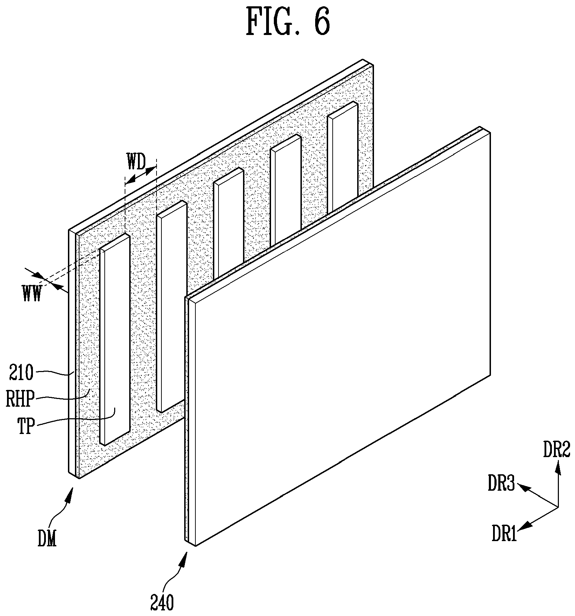

The heat dissipation module 240 may be configured to dissipate heat generated from the display module DM, the driving circuit substrate 250, and the like to the outside. For example, the heat dissipation module 240 may be configured to dissipate heat generated from the display panel 210, the data driver 220, the driving circuit substrate 250, and the like to the outside. Characteristics and configurations of the heat dissipation module 240 in accordance with embodiments will be described in more detail with reference to FIG. 6 and the following figures.

The driving circuit substrate 250 may include circuit components such as the timing controller 310. The timing controller 310, along with at least some components of the data driver 220, may be formed in a single integrated circuit. In the following, an example is given where the timing controller 310 and the data driver 220 are mounted in the electronic device 100 as separate circuit components, but the arrangement is not limited thereto. An additional power generation circuit (not illustrated) for generating various constant voltages supplied to the display module DM may be mounted on the driving circuit substrate 250. The power generation circuit may be implemented, for example, using a power management integrated circuit (PMIC).

The bottom cover BC may be configured to cover the display panel 210, the heat dissipation module 240, and the driving circuit substrate 250, and the like. The bottom cover BC may protect the aforementioned components from external impact or contaminants.

The display module DM may include the display panel 210, the data driver 220, the scan driver 230, and so on.

A plurality of pixels PX are disposed in the display panel 210. A plurality of data lines DL1, ..., and DLm (where m is an integer of 2 or more), a plurality of scan lines SL1, SL2, ..., and SLn (where n is an integer of 2 or more), and so on, which are electrically connected to the plurality of pixels PX, may be disposed in the display panel 210. One or more power voltage lines configured to apply power voltages (e.g., a first power voltage ELVDD, a second power voltage ELVSS, and the like) to the plurality of pixels PX may be disposed in the display panel 210.

The display panel 210 may include a display area DA in which the plurality of pixels PX are disposed, and a non-display area positioned in a peripheral area of the display area DA (e.g., an edge area of the display area DA).

Although the display panel 210 may be formed to be flat (for example, uniformly flat), it is not limited thereto. For example, the display panel 210 may include a curved surface portion (not illustrated) formed on each of left and right ends thereof. The curved surface portion may have a constant curvature or a variable curvature. In addition, the display panel 210 may be formed to be flexible so that the display panel 210 can be bent, curved, folded, or rolled.

Each of the pixels PX may include two or more sub-pixels. For example, the sub-pixels may be arranged in a matrix structure, or may be arranged in a PENTILE^{™} structure or the like. However, they are not limited to the foregoing structures.

The plurality of scan lines SL1 to SLn may be disposed in the display panel 210 and extend in a first direction DR1. The first direction DR1 may be, for example, a direction from the left to the right of the display panel 210. However, they are not limited to the foregoing structure.

The plurality of data lines DL1 to DLm may be disposed in the display panel 210 and extend in a second direction DR2. The second direction DR2 may be a direction different from the first direction DR1. For example, the second direction DR2 may be a direction perpendicular to the first direction DR1. The second direction DR2 may be, for example, a direction from an upper side to a lower side of the display panel 210.

The scan driver 230 may be configured to output scan signals with high-level voltage or low-level voltage to a plurality of scan lines SL1 to SLn in response to an scan driver control signal SCS received from the timing controller 310. For example, the scan driver control signal SCS may include a start signal instructing a frame to start, a horizontal synchronization signal for outputting a scan signal at a correct timing at which a data voltage is applied, and the like.

The scan driver 230 may include a plurality of stage circuits STG configured to supply scan signals to the plurality of scan lines SL1 to SLn.

The scan driver 230 may be implemented as an integrated circuit (e.g., a gate driver integrated circuit (GDIC)) formed separately from the display panel 210. The scan driver 230 may be formed along with the display panel 210, and may be formed in at least some areas on the non-display area of the display panel 210. At least a portion of the scan driver 230 may be positioned to overlap the display area DA.

The data driver 220 may supply data voltages to the plurality of data lines DL1 to DLm. The data driver 220 may generate data voltages based on image data DATA and a data driver control signal DCS received from the timing controller 310, and output the generated data voltages to the plurality of data lines DL1 to DLm at correct timings. The data driver control signal DCS may include, for example, a source start pulse (SSP), a source shift clock (SSC), a source output enable signal (SOE), and the like.

The data driver 220 may include, for example, a source printed circuit board SPCB, a circuit film CF, and a data driving integrated circuit D-IC, and the like. The source printed circuit board SPCB may be configured to transmit various voltages to the data driving integrated circuit D-IC. The circuit film CF may connect between the source printed circuit board SPCB and the display panel 210. The data driving integrated circuit D-IC may be disposed on the circuit film CF.

The timing controller 310 may be configured to control the data driver 220 and the scan driver 230. The timing controller 310 may receive control signals (e.g., a synchronization signal, a data enable signal, and the like), a clock signal, and the like from external devices (e.g., a host, a set-top box, and the like). The timing controller 310 may generate and output control signals DCS and SCS to control the data driver 220, the scan driver 230, and the like, based on the received control signal and clock signal.

The timing controller 310 may be disposed in the electronic device 100 in the form of a logic or a processor. The timing controller 310 may include one or more registers.

The display module DM may be used not only as a portable electronic device such as a mobile phone, a smart phone, a tablet personal computer (a table PC), a smart watch, a watch phone, a mobile communication terminal, an electronic notebook, an electronic book, a portable multimedia player (PMP), a navigation device, and an ultra-mobile personal computer (UMPC), but also as a display screen of various products such as a television, a notebook, a monitor, an advertisement panel, and an Internet of Things (IoT) device. The display module DM may also be used as a display screen for virtual reality (VR) devices, augmented reality (AR) devices, and the like.

In the case where the display module DM is used as a display screen for VR devices, AR devices, and the like, the electronic device 100 may be positioned remarkably close to the eyes of the user. In the case where the display module DM is used as a display screen for VR devices, AR devices, and the like, the electronic device 100 may have a high pixel density. As one method to increase the pixel density, the pixels PX may be formed on a silicon substrate. The technology of forming pixel circuits and associated light emitting elements (e.g., organic light emitting diodes (OLED)) on the silicon substrate may be referred to as OLEDoS (OLED on Silicon).

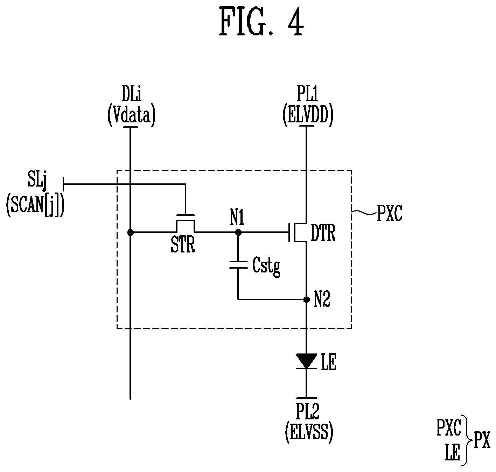

FIG. 4 is an equivalent circuit diagram of the pixel PX.

The pixel PX may include a pixel circuit PXC and a light emitting element LE.

The pixel circuit PXC may include one or more transistors and one or more capacitors. For example, referring to FIG. 4, the pixel circuit PXC may include a first transistor DTR, a second transistor STR, and a storage capacitor Cstg. However, the pixel circuit PXC is not limited to the aforementioned structure, and the pixel circuit PXC may include three or more transistors or may include two or more capacitors. Hereinafter, for the sake of explanation, an example will be described where the pixel circuit PXC includes two transistors and one capacitor.

The first transistor DTR may include a first electrode (e.g., either a source electrode or a drain electrode), a second electrode (e.g., a remaining one of the source electrode and the drain electrode), and a gate electrode. The first electrode (e.g., the drain electrode) of the first transistor DTR may be connected (e.g., electrically connected) to a first power supply line PL1. The second electrode (e.g., the source electrode) of the first transistor DTR may be connected (e.g., electrically connected) to a second node N2. The gate electrode of the first transistor DTR may be connected (e.g., electrically connected) to a first node N1. Depending on the magnitude of voltage applied to the first node N1, the magnitude of current (e.g., driving current) flowing through the first transistor DTR may be adjusted. The first power voltage ELVDD may be applied to the first power supply line PL1. The first power voltage ELVDD may be a high-potential power voltage. The first transistor DTR may be referred to as a driving transistor.

The second transistor STR may be configured to switch electrical connection between the data line DLi (where i is an integer between 1 and m) and the first node N1 in response to a scan signal SCAN[j] (where j is an integer between 1 and n). The scan signal SCAN[j] may be applied to a scan line SLj. The scan signal SCAN[j] may have a turn-on level (e.g., either a high level or a low level) or a turn-off level (e.g., the other one of the high level and the low level). If the second transistor STR is turned on, a data voltage Vdata or a voltage corresponding to the data voltage Vdata may be applied to the first node N1. The second transistor STR may be referred to as a scan transistor.

The storage capacitor Cstg may be configured to maintain a difference in voltage between the first node N1 and the second node N2. The storage capacitor Cstg may include a first electrode connected (e.g., electrically connected) to the first node N1, and a second electrode connected (e.g., electrically connected) to the second node N2. The storage capacitor Cstg may be intentionally formed as a physical capacitor element rather than a parasitic capacitor.

The light emitting element LE may be connected between the second node N2 and a second power supply line PL2. The second power voltage ELVSS may be applied to the second power supply line PL2. The second power voltage ELVSS may be a low-potential power voltage. The light emitting element LE may include a first electrode (e.g., an anode electrode) connected (e.g., electrically connected) to the second node N2, and a second electrode (e.g., a cathode electrode) connected (e.g., electrically connected) to the second power supply line PL2. The light emitting element LE may further include an emission layer disposed between the anode electrode and the cathode electrode, and configured to emit light.

The emission layer may include high-molecular-weight or low-molecular-weight organic light emitting material. The emission layer may include inorganic light emitting material, or may include quantum dots. For example, the emission layer may include high-molecular-weight or low-molecular-weight organic light emitting material for emitting light in a certain wavelength band (e.g., a blue wavelength band, a green wavelength band, or a red wavelength band). However, the implementation is not limited to the aforementioned example.

One or more transistors that form the pixel circuit PXC may include a P-type or N-type semiconductor layer. For example, at least one of the first and second transistors DTR and STR may be implemented as a field effect transistor (FET) including a P-channel metal oxide semiconductor (PMOS). For example, at least one of the first and second transistors DTR and STR may be implemented as a field effect transistor including an N-channel metal oxide semiconductor (NMOS).

Referring to FIG. 4, an example is given where each of the first and second transistors DTR and STR includes an N-channel metal oxide semiconductor. However, they are not limited to the foregoing structure. For example, at least one of the first and second transistors DTR and STR may be implemented as a field effect transistor including a P-channel metal oxide semiconductor (NMOS).

Transistors that form the pixel circuit PXC may include an amorphous silicon (a-Si) semiconductor, an oxide semiconductor, a low temperature polycrystalline silicon (LTPS) semiconductor, and so on. For example, one of two transistors that form the pixel circuit PXC may include a low temperature poly silicon semiconductor, and the other of the two transistors may include an oxide semiconductor.

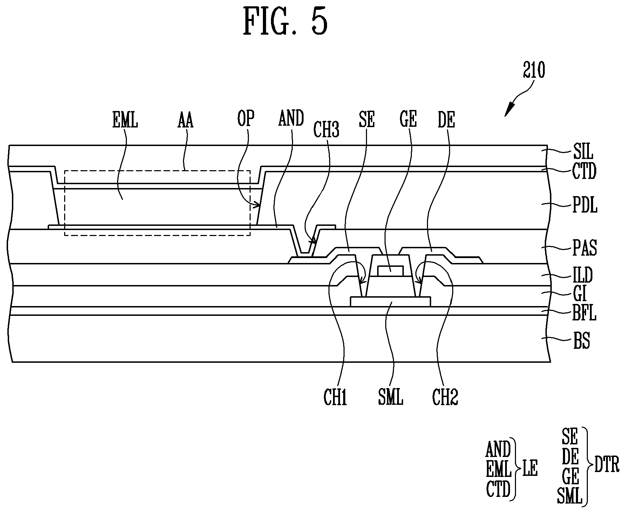

FIG. 5 is a sectional view of the display panel 210 including the pixel PX of FIG. 4.

The display panel 210 may include a base substrate BS, a buffer layer BFL, a semiconductor layer SML, a gate insulating layer GI, a gate electrode GE, an interlayer insulating layer ILD, a source electrode SE, a drain electrode DE, a passivation layer PAS, a pixel defining layer PDL, a light emitting element LE, an encapsulation layer SIL, and so one.

The buffer layer BFL may be disposed on one surface of the base substrate BS. The buffer layer BFL may be configured to prevent penetration or diffusion of impurities from the base substrate BS during a fabrication process. The buffer layer BFL may prevent impurities from diffusing into the semiconductor layer SML. Impurities may be drawn from the outside or may be generated by thermal decomposition of the base substrate BS. Impurities may include gas or natrium discharged from the base substrate BS. The buffer layer BFL may block water penetrated from the outside.

The semiconductor layer SML may be disposed on the buffer layer BFL. The semiconductor layer SML may include a polycrystalline silicon semiconductor, an amorphous silicon semiconductor, an oxide semiconductor, and so on. The semiconductor layer SML may include a channel area where electrons or holes can move, and a first ion-doped area (e.g., a source area) and a second ion-doped area (e.g., a drain area) with the channel area interposed therebetween.

The gate insulating layer GI may be disposed on the semiconductor layer SML. The gate insulating layer GI may cover the semiconductor layer SML. The gate insulating layer GI may include an organic layer and/or inorganic layer. The gate insulating layer GI may include a plurality of inorganic thin films. The inorganic thin films may include a silicon nitride layer, a silicon oxide layer, and the like.

The gate electrode GE of the first transistor DTR may be disposed on the gate insulating layer GI.

The interlayer insulating layer ILD may be disposed on the gate electrode GE. The interlayer insulating layer ILD may include an organic layer and/or inorganic layer. The interlayer insulating layer ILD may include a plurality of inorganic thin films. The inorganic thin films may include a silicon nitride layer, a silicon oxide layer, and the like.

The first electrode (e.g., the drain electrode DE) and the second electrode (e.g., the source electrode SE) of the first transistor DTR may be disposed on the interlayer insulating layer ILD. The first electrode (i.e., the drain electrode DE) of the first transistor DTR may be connected (e.g., electrically connected) to the semiconductor layer SML of the first transistor DTR through a second contact hole CH2. The second electrode (i.e., the source electrode SE) of the first transistor DTR may be connected (e.g., electrically connected) to the semiconductor layer SML of the first transistor DTR through a first contact hole CH1. The first contact hole CH1 may be formed by removing at least portions of the gate insulating layer GI and the interlayer insulating layer ILD. The second contact hole CH2 may be formed by removing at least portions of the gate insulating layer GI and the interlayer insulating layer ILD.

The passivation layer PAS may be disposed on the interlayer insulating layer ILD to cover the first electrode and the second electrode of the first transistor DTR. The passivation layer PAS may include an organic layer and/or inorganic layer. For example, the passivation layer PAS may include an organic layer to planarize an area over the first electrode and the second electrode.

The pixel defining layer PDL is disposed on the passivation layer PAS. The pixel defining layer PDL may define the opening OP by removing at least a portion thereof. The light emitting element LE may be formed in an active area AA corresponding to the opening OP. The active area AA may correspond to an emission area where light is emitted from the light emitting element LE.

The light emitting element LE may be disposed on the passivation layer PAS. The light emitting element LE may be implemented, for example, using an organic light emitting diode (OLED) including an organic emission layer. The light emitting element LE may be implemented using an inorganic light emitting element including an inorganic emission layer. Hereinafter, for the sake of explanation, an example will be described where the light emitting element LE includes an organic light emitting diode, but it should be noted that it is not limited thereto.

The anode electrode AND may be disposed on the passivation layer PAS. The anode electrode AND may be connected (e.g., electrically connected) to the second electrode of the first transistor DTR through a third contact hole CH3. The third contact hole CH3 may be formed in the passivation layer PAS. The anode electrode AND may have conductivity. The anode electrode AND may be either a pixel electrode or a positive electrode. The anode electrode AND may have light transmittance. Where the anode electrode AND is a transparent electrode, the anode electrode AND may be made of transparent metal oxide such as indium tin oxide (ITO), indium zinc oxide (IZO), zinc oxide (ZnO), indium tin zinc oxide (ITZO), or the like. Where the anode electrode AND is a transflective electrode or a reflective electrode, the anode electrode AND may include Ag, Mg, Al, Pt, Pd, Au, Ni, Nd, Ir, Cr, or a mixture of the aforementioned metals. The anode electrode AND may have a single-layer or multilayer structure made of transparent metal oxides or metals. For example, the anode electrode AND may have a single-layer structure including ITO, Ag, or a metallic mixture (e.g., a mixture of Ag and Mg), a double-layer structure of ITO/Mg or ITO/MgF, or a triple-layer structure of ITO/Ag/ITO, but it is not limited to the aforementioned.

The emission layer EML may be disposed on the anode electrode AND. A first functional layer (not illustrated) may be interposed between the anode electrode AND and the emission layer EML. A second functional layer (not illustrated) may be interposed between the emission layer EML and the cathode electrode CTD.

The first functional layer may be positioned on the anode electrode AND, and configured to inject and/or transport holes. The first functional layer may include at least one of a hole injection layer (not illustrated), a hole transport layer (not illustrated), and an electron blocking layer (not illustrated). The first functional layer may have, for example, a single layer formed of a single material, a single layer formed of a plurality of different materials, or a multilayer structure having a plurality of layers formed of a plurality of different materials.

The emission layer EML may have a single layer formed of a single material, a single layer formed of a plurality of different materials, or a multilayer structure having a plurality of layers formed of a plurality of different materials. The emission layer EML may be formed using various methods such as a vacuum deposition method, a spin coating method, a casting method, a Langmuir-Blodgett (LB) method, an inkjet printing method, a laser printing method, and a laser-induced thermal imaging (LITI) method. The emission layer EML is not limited to specific material, so long as it is material that is commonly used. For example, the emission layer EML may be formed of material that emits light in the red wavelength band, light in the green wavelength band, and/or light in the blue wavelength band, and may include fluorescent or phosphorescent material. Furthermore, the emission layer EML may include a host and a dopant.

The second functional layer may be positioned under the cathode electrode CTD, and configured to inject and/or transport electrons. The second functional layer may include an electron transport layer (not illustrated) and an electron injection layer (not illustrated), but is not limited thereto. The second functional layer may have a structure including an electron transport layer and an electron injection layer that are successively stacked. Furthermore, the second functional layer may have a single-layer structure with a mixture of two or more materials, but it is not limited thereto. The second functional layer may be formed using various methods such as a vacuum deposition method, a spin coating method, a casting method, an LB method, an inkjet printing method, a laser printing method, and a laser-induced thermal imaging (LITI) method.

The cathode electrode CTD may be disposed on the emission layer EML, and may be made of a metal or alloy with a low work function or an electrically conductive compound, or a mixture of the aforementioned materials. The cathode electrode CTD may be either a common electrode or a negative electrode. The cathode electrode CTD may be a transmissive electrode, a transflective electrode, or a reflective electrode. In the case where the cathode electrode CTD is a transmissive electrode, the cathode electrode CTD may include Li, Ca, LiF, Al, Mg, Ag or a compound or mixture thereof (e.g., a mixture of Ag and Mg), or multilayered structure material such as LiF/Ca, LiF/Al. The cathode electrode CTD may include an auxiliary electrode. The auxiliary electrode may include transparent metal oxide such as indium tin oxide (ITO), indium zinc oxide (IZO), zinc oxide (ZnO), or indium tin zinc oxide (ITZO). In the case where the cathode electrode CTD is a transflective electrode or reflective electrode, the cathode electrode CTD may include Ag, Mg, Al, Pt, Pd, Au, Ni, Nd, Ir, Cr, Li, Ca, LiF or a compound or mixture thereof (e.g., a mixture of Ag and Mg), or multilayered structure material such as LiF/Ca, LiF/Al. Alternatively, the cathode electrode CTD may include transparent metal oxide formed of material such as indium tin oxide (ITO), indium zinc oxide (IZO), zinc oxide (ZnO), or indium tin zinc oxide (ITZO).

In the case where the light emitting element LE is a top-emission-type light emitting element, the anode electrode AND may be a reflective electrode, and the cathode electrode CTD may be a transmissive electrode or a transflective electrode. In the case where the light emitting element LE is a bottom-emission-type light emitting element, the anode electrode AND may be a transmissive electrode or a transflective electrode, and the cathode electrode CTD may be a reflective electrode.

FIG. 6 is a perspective view of the display module DM and the heat dissipation module 240.

A heat dissipation layer RHP may be disposed on a rear surface of the display panel 210. For example, a front surface of the display panel 210 is a surface of the display panel 210 on which images IM (refer to FIG. 1) can be displayed, and the rear surface of the display panel 210 is a surface opposite the front surface of the display panel 210, where images IM are not displayed.

The heat dissipation layer RHP may be configured to dissipate heat generated from the display module DM (e.g., the display panel 210). The heat dissipation layer RHP may have a heat radiation rate (or heat emissivity) of a certain value or more. For example, the heat radiation rate of the heat dissipation layer RHP may be 0.8 or more. The heat dissipation layer RHP may be a coated layer formed by applying heat-dissipating paint. The heat dissipation layer RHP may include, for example, ceramic composites. The heat dissipation module 240 may further be disposed under the display module DM (e.g., the display panel 210) to enhance the heat dissipation of the display module DM. When the heat dissipation module 240 is disposed under the display module DM, the heat dissipation layer RHP disposed on the rear surface of the display panel 210 may be omitted.

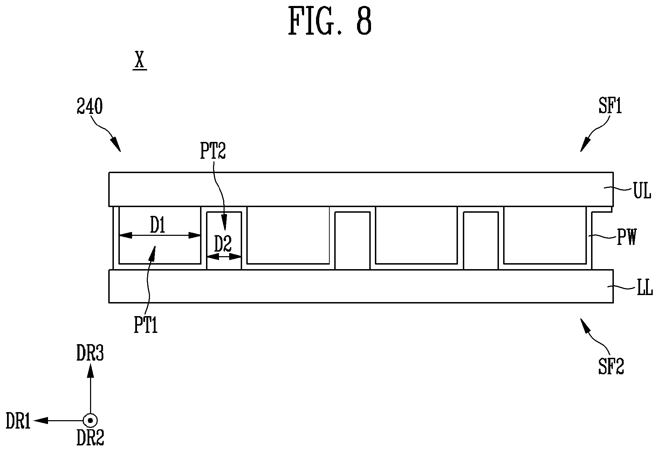

An adhesive component TP may be disposed on the rear surface of the display panel 210. The adhesive component TP may attach the display module DM (e.g., the display panel 210) to the heat dissipation module 240 (for example, through adhesion), for example, the first planar component UL (see FIG. 8). The adhesive component TP may have a certain thickness WW in the third direction DR3. The adhesive component TP may extend in the second direction DR2.

A plurality of adhesive components TP may be disposed on the rear surface of the display panel 210. The adhesive components TP may be disposed to be spaced apart from each other in the first direction DR1. For example, the adhesive components TP may be disposed to be spaced apart from each other by a certain distance WD. Each of the adhesive components TP may extend in the second direction DR2.

The adhesive component TP may include one or more air holes. The air holes may be provided to absorb impacts exerted on the adhesive component TP. The adhesive component TP may be interposed between the display module DM (e.g., the display panel 210) and the heat dissipation module 240 to absorb external impacts. The adhesive component TP may be implemented, for example, using foam tape.

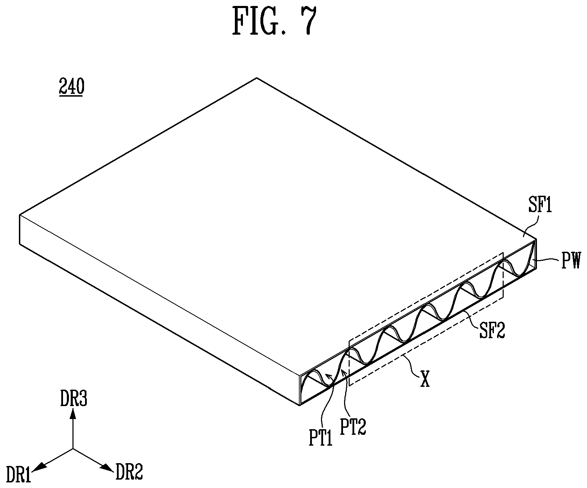

FIG. 7 is a perspective sectional view of the heat dissipation module 240 in accordance with an embodiment.

Referring to FIG. 7, the heat dissipation module 240 may include a first surface (first wall) SF1 and a second surface (second wall) SF2, and a partition wall PW disposed between the first surface SF1 and the second surface SF2.

The first surface SF1 may refer to a surface facing the display module DM (refer to FIG. 6). The first surface SF1 may be a surface that is attached to the adhesive component TP (refer to FIG. 6).

The second surface SF2 may refer to a surface disposed away from the display module DM and facing (opposite to) the first surface SF1.

The partition wall PW may include corrugations. The corrugations may form a first path PT1 and a second path PT2 that are isolated from each other. The first path PT1 may be formed between the partition wall PW and the first surface SF1. The second path PT2 may be formed between the partition wall PW and the second surface SF2.

The first path PT1 may be an area formed to receive fluid (e.g., liquid) for heat dissipation. The first path PT1 may include one or more closed loops. The fluid may include an air layer (e.g., bubble). Due to heat applied to at least a portion of the first path PT1, the volume of the air layer in the corresponding area may expand. Due to heat dissipated from a remaining portion of the first path PT1, the volume of the air layer in the corresponding area may contract. As a result of expansion and contraction, the fluid may vibrate. Heat is transferred through the fluid, so that heat dissipation can be performed in the heat dissipation module 240. The first path PT1 may be enclosed by the partition wall PW and the first surface (or wall) SF1.

The second path PT2 may be an area exposed to the outside. The second path PT2 may be an area through which external air flows into the heat dissipation module 240, or internal air is discharged out of the heat dissipation module 240. For example, the second path PT2 may be connected to the outside of the heat dissipation module 240 in the first direction DR1 and/or the second direction DR2 (i.e., communicates with an outside of the heat dissipation module 240). The second path PT2 may be connected to the outside of the heat dissipation module 240 in the third direction DR3. The second path PT2 may be enclosed by the partition wall PW. The second path PT2 may also be enclosed by the second surface SF2.

The first surface SF1 and the partition wall PW may be formed integrally with each other. For example, the first surface SF1 and the partition wall PW may be formed integrally with each other in such a way that the first surface SF1 and the partition wall PW are successively formed using a 3-dimensional (3D) printing method. However, the method of integrally forming the first surface SF1 and the partition wall PW is not limited to the 3D printing method, and the aforementioned example is merely illustrative.

The first surface SF1 and the partition wall PW may be formed as separate components. For example, the partition wall PW may be attached (or coupled) to the first surface SF1 which has a planar shape, thus forming the heat dissipation module 240. The second surface (wall) SF2 may be formed along with the first surface SF1 and the partition wall PW through the aforementioned 3D printing method. The second surface SF2 may be separately prepared and be attached (or coupled) to the partition wall PW, thus forming the heat dissipation module 240.

Hereinafter, for the sake of explanation, an example will be described where the heat dissipation module 240 includes the second surface SF2, but it should be noted that it is not limited thereto. Hereinafter, for the sake of explanation, an example will be described where the heat dissipation module 240 has a structure such that the first surface SF1, the partition wall PW, and the second surface SF2 are formed separately from each other, but it should be noted that it is not limited thereto.

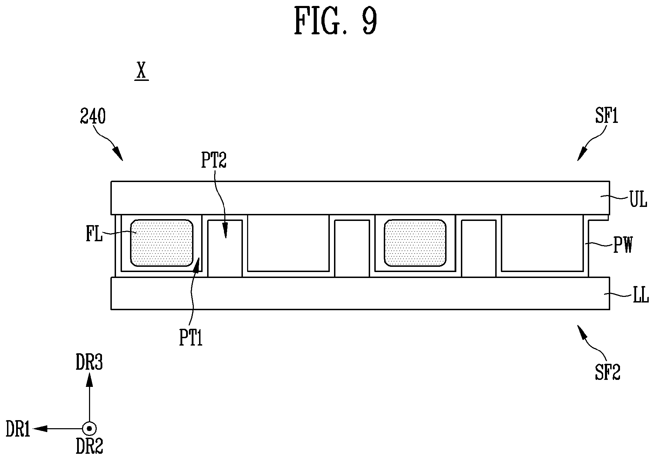

FIG. 8 is a sectional view illustrating area X in the heat dissipation module 240 of FIG. 7. FIG. 9 is a diagram for describing the heat dissipation module 240 with liquid FL injected thereinto.

Referring to FIG. 8 and FIG. 9, the heat dissipation module 240 may include a first planar component UL or plate (e.g., a first plate-shaped member), a partition wall PW, and a second planar component LL or plate (e.g., a second plate-shaped member).

The first planar component UL has a first surface SF1, being an exterior surface of the heat dissipation module 240. The first planar component UL may be connected (e.g., attached or coupled) to the partition wall PW on an interior surface thereof facing away from (opposite) the first surface SF1. The first planar component UL may include a high heat transfer material, for example, metal. In another example, the first planar component UL may include a polymer with thermal conductivity lower than that of metal (e.g., copper (Cu), gold (Au), etc.). For example, since substantial heat dissipation in the heat dissipation module 240 is performed by the liquid FL filled between the partition wall PW and the first planar component UL, the material for the first planar component UL may be selected from among materials with relatively lower thermal conductivity than metal (e.g., polymers).

The second planar component LL has a second surface SF2, being an exterior surface of the heat dissipation module 240 opposite the first surface. The second planar component LL may be connected (e.g., attached or coupled) to the partition wall PW on an interior surface thereof facing away from the second surface SF2. The second planar component LL may include a high heat transfer material, for example, metal. In another example, the second planar component LL may include a polymer with thermal conductivity lower than that of metal (e.g., copper (Cu), gold (Au), etc.). For example, since substantial heat dissipation in the heat dissipation module 240 is performed by the liquid FL filled between the partition wall PW and the second planar component LL, the material for the second planar component LL may be selected from among materials with relatively lower thermal conductivity than the metal (e.g., polymers).

The first planar component UL may enhance the rigidity of the heat dissipation module 240. The second planar component LL may also enhance the rigidity of the heat dissipation module 240. The first planar component UL and the second planar component LL may also function as a chassis to prevent the display panel 210 (refer to FIG. 2) or the like from being damaged due to forces applied to the electronic device 100 (refer to FIG. 1). The first planar component UL and the second planar component LL may include, for example, material that has relatively low thermal conductivity and is capable of providing relatively high rigidity.

The partition wall PW may form a first path PT1 and a second path PT2. Each of the first path PT1 and the second path PT2 have a certain width. For example, each channel of the first path PT1 may have a uniform width of a first dimension D1. For example, each channel of the second path PT2 may have a uniform width of a second dimension D2.

The first dimension D1 is a dimension sufficient for allowing the liquid FL filled in the first path PT1 to move through a capillary phenomenon to transfer heat, and is not limited in dimension. The first dimension D1 may be determined and designed to vary depending on the type of liquid FL accommodated in the first path PT1.

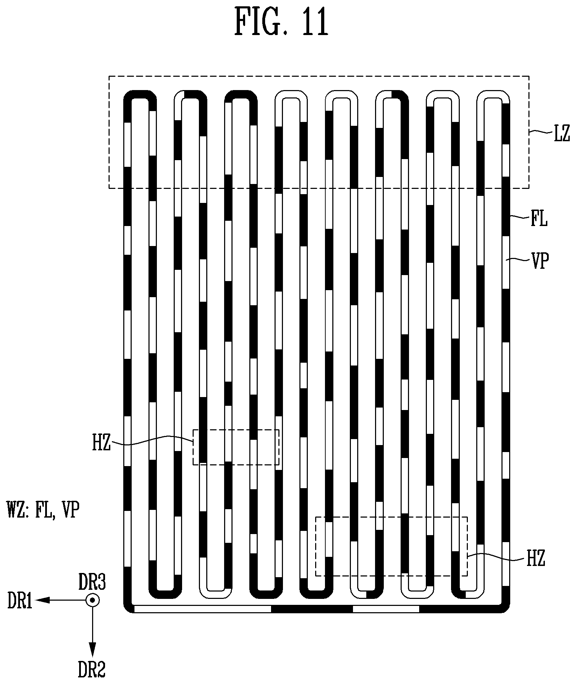

The liquid FL may be, for example, water, Freon, methanol, or ethanol, but is not limited thereto. The liquid FL and an air layer (e.g., bubbles) VP (refer to FIG. 11) inside the liquid FL may be referred to as working fluid WZ (refer to FIG. 11).

The first dimension D1 may be greater than the second dimension D2. For example, an increase in surface area of a portion of the first planar component UL that contacts the liquid FL may enhance the heat dissipation effect of the heat dissipation module 240. However, implementations are not limited to the aforementioned example. The first dimension D1 may be identical (or substantially identical) to the second dimension D2. The first dimension D1 may be less than the second dimension D2.

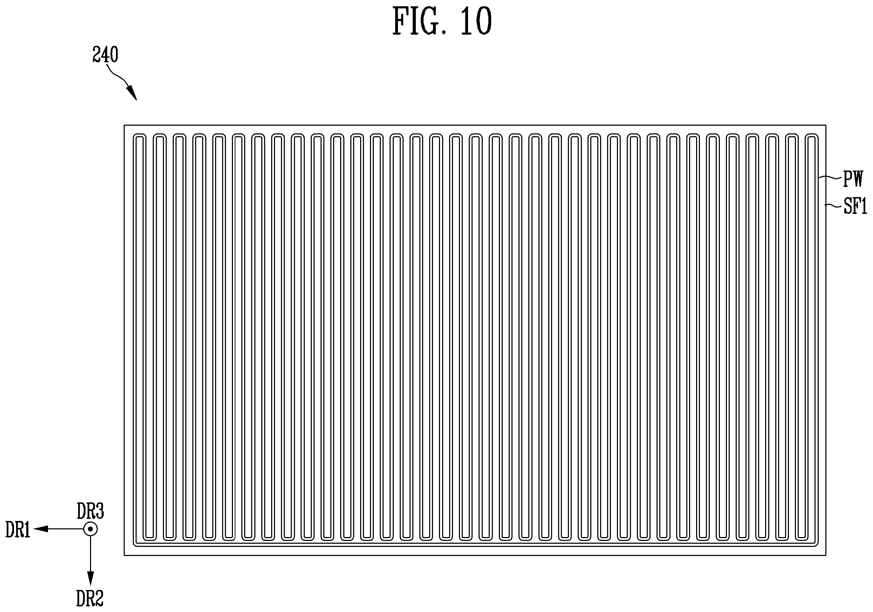

FIG. 10 is a rear perspective view of the heat dissipation module 240. FIG. 11 is a diagram for describing performance of heat dissipation in the heat dissipation module 240 (refer to FIG. 10).

Referring to FIG. 10, there is an illustration of a rear view of the heat dissipation module 240 of FIG. 7, and the representation of the second surface SF2 (planar component LL) is omitted to effectively illustrate the arrangement of the partition wall PW in the heat dissipation module 240.

The partition wall PW may form a closed loop. The aforementioned liquid FL (refer to FIG. 9) may be contained in the closed loop. The partition wall PW may further include an opening (not illustrated) to allow the liquid FL to be injected into a space formed by the closed loop in the partition wall PW. During a process of fabricating the partition wall PW (or the heat dissipation module 240), the liquid FL may be injected into a space formed by the closed loop in the partition wall PW. After injecting the liquid FL, the opening to allow the liquid FL to be injected into the space formed by the closed loop in the partition wall PW may be sealed. In this case, the partition wall PW may have no opening.

Referring to FIG. 10, there is illustrated an example in which the heat dissipation module 240 includes only one closed loop defined by the partitioned wall PW. However, the arrangement is not limited to the foregoing structure. For example, two or more closed loops may be included in the heat dissipation module 240.

Two or more closed loops may be placed on a plane defined by the first direction DR1 and the second direction DR2. The two or more closed loops, for example, may be arranged parallel to each other in the first direction DR1 or the second direction DR2, but the arrangement is not limited thereto.

Referring to FIGS. 10 and 11, a high-temperature area HZ and a low-temperature area LZ may be defined in the heat dissipation module 240. Referring also to FIG. 2, the high-temperature area HZ (or high-temperature zone HZ) and the low-temperature area LZ (or low-temperature zone LZ) may be defined in the electronic device 100 in response to the surrounding temperature of the heat dissipation module 240. The high-temperature area HZ and the low-temperature area LZ in the heat dissipation module 240 may be adaptively variable and may not be predefined areas. The high-temperature area HZ may be an area positioned to overlap the data driver 220 (e.g., the data driving integrated circuit D-IC). The high-temperature area HZ, for example, may be an area overlapping the display panel 210 that displays the image IM (refer to FIG. 1) with high-luminance. The low-temperature area LZ, for example, may be an area distant from the data driver 220 (e.g., referring to FIG. 2, an area of an end of the display panel 210 opposite to the second direction DR2). However, it should be noted that the high-temperature area HZ and the low-temperature area LZ are relatively defined, and the arrangement is not limited to the aforementioned example.

Referring to FIG. 11, the working fluid WZ may include liquid FL and an air layer VP. The air layer VP (e.g., a vapor) may increase in volume in the high-temperature area HZ, and decrease in volume in the low-temperature area LZ. If the volume of the air layer VP increases in the high-temperature area HZ, the air layer VP may displace the liquid FL. The liquid FL that is displaced from the high-temperature area HZ by the air layer VP may move into the low-temperature area LZ. In the low-temperature area LZ, the liquid FL releases heat. Thereby, the heat dissipation module 240 (refer to FIG. 10) may perform the heat dissipation function.

The volume of the air layer VP (or the volume of the liquid FL) in the working fluid WZ may be designed without restriction within a range that allows the movement of the liquid FL through the capillary phenomenon according to the design of those skilled in the art. For example, the volume of the liquid FL in the working fluid WZ may be approximately 20% or more and be less than 100%. For example, the volume of the liquid FL in the working fluid WZ may be approximately 50%.

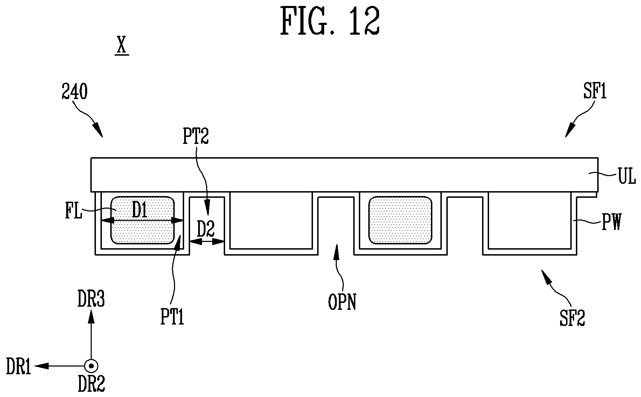

FIG. 12 is a sectional view illustrating area X in another example of the heat dissipation module 240 of FIG. 7.

Referring to FIG. 12, in the heat dissipation module 240, a second planar component LL (refer to FIG. 9) is omitted. Therefore, the second path PT2 (or the partition wall PW) may include an opening OPN, and is connected to the outside of the heat dissipation module 240 in the opening OPN. External air of the heat dissipation module 240 may easily flow through the second path PT2 through the opening OPN. Hence, heat exchange between the liquid FL in the first path PT1 and the external gas in the second path PT2 may be more easily performed. Accordingly, the heat dissipation effect of the heat dissipation module 240 may be enhanced.

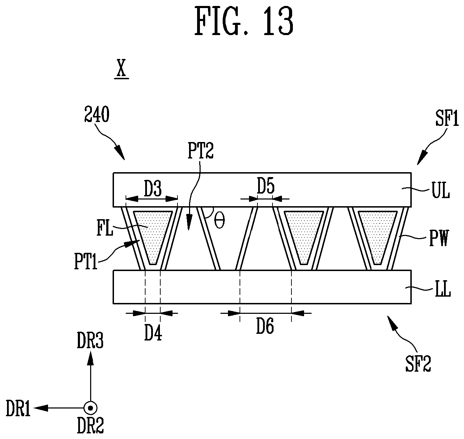

FIG. 13 is a sectional view illustrating area X in another example of the heat dissipation module 240 of FIG. 7.

Referring to FIG. 13, a certain inclined angle θ may be formed between the partition wall PW and the first surface SF1. For example, the first path PT1 may have a width of a third dimension D3 on a side thereof adjacent to the first surface SF1, and may have a width of a fourth dimension D4 different from the third dimension D3 on a side thereof adjacent to the second surface SF2. For example, the second path PT2 may have a width of a fifth dimension D5 on a side thereof adjacent to the first surface SF1, and may have a width of a sixth dimension D6 different from the fifth dimension D5 on a side thereof adjacent to the second surface SF2.

The certain inclined angle θ may be an acute angle less than the right angle (90°). For example, in an area corresponding to the first path PT1, the inclined angle θ between the partition wall PW and the first surface SF1 may be an acute angle. In the aforementioned example, the third dimension D3 may be greater than the fourth dimension D4. The fifth dimension D5 may be less than the sixth dimension D6. In the aforementioned example, the liquid FL may have a relatively larger contact area with an area of the first planar component UL where heat is introduced. Furthermore, as a result of the diagonal arrangement of the partition wall PW, a surface area with which the liquid FL contacts the second path PT2 may be relatively increased. Consequently, the heat dissipation effect of the heat dissipation module 240 may be enhanced.

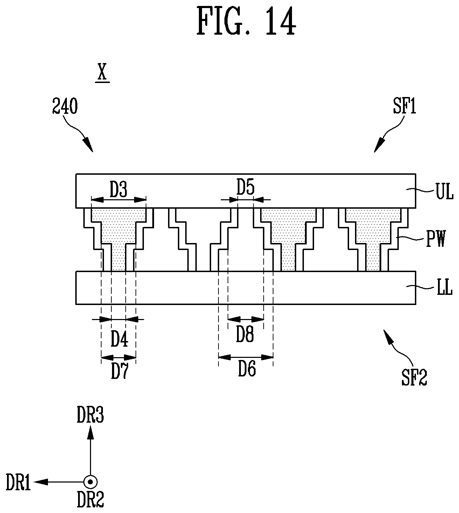

FIG. 14 is a sectional view illustrating area X in another example of the heat dissipation module 240 of FIG. 7.

Referring to FIG. 14, there is illustrated an example where the partition wall PW includes one or more stepped portions. For example, the first path PT1 may have a width of a third dimension D3 on a side thereof adjacent to the first surface SF1, and may have a width of a fourth dimension D4 different from the third dimension D3 on a side thereof adjacent to the second surface SF2. For example, the second path PT2 may have a width of a fifth dimension D5 on a side thereof adjacent to the first surface SF1, and may have a width of a sixth dimension D6 different from the fifth dimension D5 on a side thereof adjacent to the second surface SF2.

An angle between the partition wall PW and the first surface SF1 may be a right angle, but is not limited thereto. An angle between the partition wall PW and the second surface SF2 may be a right angle, but is not limited thereto.

In an example where the partition wall PW includes one stepped portion, the first path PT1 may have widths of the third dimension D3 and the fourth dimension D4. In the aforementioned example, the second path PT2 may have widths of the fifth dimension D5 and the sixth dimension D6.

In an example where the partition wall PW includes two or more stepped portions, the first path PT1 may have widths of the third dimension D3, the fourth dimension D4, and a seventh dimension D7. The seventh dimension D7 may be less than the third dimension D3 and greater than the fourth dimension D4. In the aforementioned example, the second path PT2 may have widths of the fifth dimension D5, the sixth dimension D6, and an eighth dimension D8. The eighth dimension D8 may be greater than the fifth dimension D5 and less than the sixth dimension D6.

In an example where the partition wall PW include two or more stepped portions, a surface area with which the liquid FL flowing through the first path PT1 contacts the second path PT2 through the partition wall PW may be increased. Therefore, the heat dissipation effect may be enhanced.

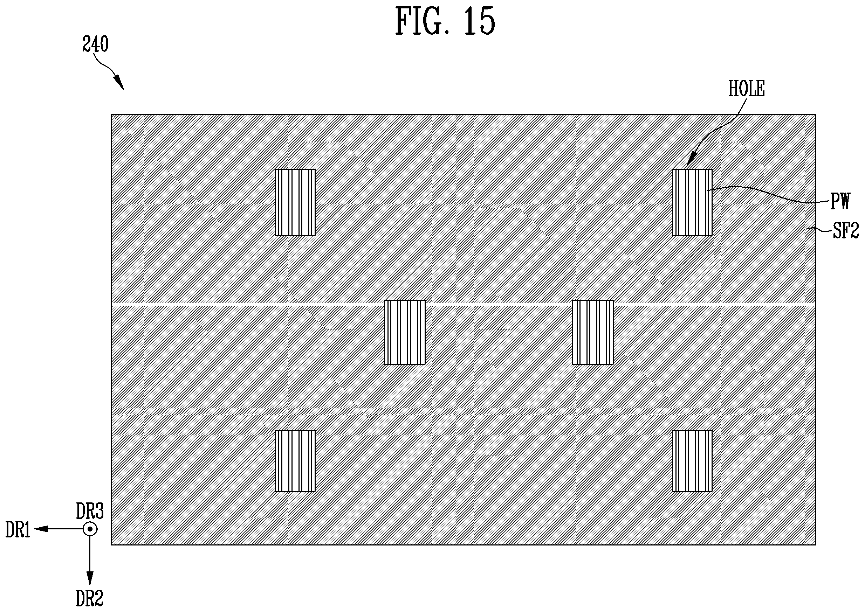

FIG. 15 is a rear view of a heat dissipation module 240.

Referring to FIG. 15, in the heat dissipation module 240, a hole HOLE is formed in the second planar component LL. The hole HOLE exposes at least a portion of the partition wall PW to the outside of the heat dissipation module 240. The hole HOLE may expose at least a portion of the partition wall PW in an area corresponding to an area in which heat dissipation in the display module DM is higher than other areas.

The second planar component LL may include a plurality of holes HOLE. The holes HOLE, for example, may be positioned adjacent to each other in the first direction DR1, or may be positioned adjacent to each other in the second direction DR2. However, the arrangement is not limited to the foregoing example.

Due to the hole HOLE, a surface area with which the partition wall PW contacts external air of the heat dissipation module 240 may increase, whereby the heat dissipation effect can be enhanced.

A heat dissipation module and an electronic device including the heat dissipation module in accordance with embodiments may be improved in heat dissipation efficiency.

Although the preferred embodiments of the present disclosure have been disclosed for illustrative purposes, those skilled in the art will appreciate that various modifications, additions and substitutions are possible, without departing from the scope of the present invention as claimed.

## Claims

1. A heat dissipation module (240) comprising:
a first plate (UL);
a partition wall (PW) coupled to the first plate (UL) and defining a first path (PT1) having one side closed by the first plate (UL), and a second path (PT2) spaced apart from the first path (PT1) and communicating with an outside of the heat dissipation module (240), the first path (PT1) forming a closed loop;
a working fluid (FL, WZ) disposed in the first path (PT1); and
a second plate (LL) coupled to the partition wall (PW) with the partition wall (PW) disposed between the first plate (UL) and the second plate (LL), wherein the second path (PT2) is disposed between the partition wall (PW) and the second plate (LL), **characterized in that** the second plate (LL) includes at least one hole (HOLE) that exposes at least a portion of the second path (PT2).

2. The heat dissipation module according to claim 1,
wherein the partition wall is disposed to be inclined with respect to the plane of the first plate and the plane of the second plate,
wherein the width of the first path tapers from the first plate to the second plate and the width of the second path tapers from the second plate to the first plate.

3. The heat dissipation module according to claim 1,
wherein the partition wall includes at least one stepped portion,
wherein the width of the first path in each of the stepped portions decreases from the first plate (UL) to the second plate (LL); and
the width of the second path in each of the stepped portions decreases from the second plate (LL) to the first plate (UL).

4. The heat dissipation module according to any one of the preceding claims, wherein the partition wall (PW) includes an opening (OPN) in an area facing away from the first plate and the second path communicates with the outside of the heat dissipation module through the opening.

5. The heat dissipation module according to claim 1, wherein the first path is wider than the second path.

6. The heat dissipation module according to any one of the preceding claims,
wherein the working fluid comprises liquid and an air layer.

7. The heat dissipation module according to claim 6, wherein a volume of the liquid in the working fluid is 20% or more and less than 100%.

8. An electronic device (100) comprising:
a display panel (210) including a plurality of pixels (PX) arranged to display an image on a front surface of the display panel; and
a heat dissipation module (240) according to any one of the preceding claims disposed on a rear surface of the display panel.

9. The electronic device according to claim 8, further comprising an adhesive component (TP) attached to the rear surface of the display panel and configured to attach the rear surface of the display panel to the first plate of the heat dissipation module.

## Patentansprüche

1. Wärmeableitungsmodul (240), umfassend:
eine erste Platte (UL);
eine Trennwand (PW), die an die erste Platte (UL) gekoppelt ist und einen ersten Pfad (PT1) mit einer durch die erste Platte (UL) geschlossenen Seite und einen zweiten Pfad (PT2), der von dem ersten Pfad (PT1) beabstandet ist und mit einer Außenseite des Wärmeableitungsmoduls (240) kommuniziert, definiert, wobei der erste Pfad (PT1) eine geschlossene Schleife bildet;
ein Arbeitsfluid (FL, WZ), das in dem ersten Pfad (PT1) angeordnet ist; und
eine zweite Platte (LL), die an die Trennwand (PW) gekoppelt ist, wobei die Trennwand (PW) zwischen der ersten Platte (UL) und der zweiten Platte (LL) angeordnet ist, wobei der zweite Pfad (PT2) zwischen der Trennwand (PW) und der zweiten Platte (LL) angeordnet ist,
**dadurch gekennzeichnet, dass**
die zweite Platte (LL) mindestens ein Loch (HOLE) aufweist, das zumindest einen Abschnitt des zweiten Pfads (PT2) freilegt.

2. Wärmeableitungsmodul nach Anspruch 1,
wobei die Trennwand dazu angeordnet ist, in Bezug auf die Ebene der ersten Platte und die Ebene der zweiten Platte geneigt zu sein,
wobei sich die Breite des ersten Pfads von der ersten Platte zu der zweiten Platte verjüngt und sich die Breite des zweiten Pfads von der zweiten Platte zu der ersten Platte verjüngt.

3. Wärmeableitungsmodul nach Anspruch 1,
wobei die Trennwand mindestens einen abgestuften Abschnitt beinhaltet,
wobei die Breite des ersten Pfads in jedem der abgestuften Abschnitte von der ersten Platte (UL) zu der zweiten Platte (LL) abnimmt; und
die Breite des zweiten Pfads in jedem der abgestuften Abschnitte von der zweiten Platte (LL) zu der ersten Platte (UL) abnimmt.

4. Wärmeableitungsmodul nach einem der vorhergehenden Ansprüche, wobei die Trennwand (PW) eine Öffnung (OPN) in einem Bereich beinhaltet, der von der ersten Platte abgewandt ist, und der zweite Pfad durch die Öffnung mit der Außenseite des Wärmeableitungsmoduls kommuniziert.

5. Wärmeableitungsmodul nach Anspruch 1, wobei der erste Pfad breiter als der zweite Pfad ist.

6. Wärmeableitungsmodul nach einem der vorhergehenden Ansprüche, wobei das Arbeitsfluid Flüssigkeit und eine Luftschicht umfasst.

7. Wärmeableitungsmodul nach Anspruch 6, wobei ein Volumen der Flüssigkeit in dem Arbeitsfluid 20 % oder mehr und weniger als 100 % beträgt.

8. Elektronische Vorrichtung (100), umfassend:
ein Anzeigefeld (210), das eine Vielzahl von Pixeln (PX) beinhaltet, die dazu eingerichtet sind, ein Bild auf einer Vorderfläche des Anzeigefeldes anzuzeigen; und
ein Wärmeableitungsmodul (240) nach einem der vorhergehenden Ansprüche, das auf einer Rückseite des Anzeigefeldes angeordnet ist.

9. Elektronische Vorrichtung nach Anspruch 8, ferner umfassend eine Klebekomponente (TP), die an der Rückseite des Anzeigefelds befestigt ist und dazu konfiguriert ist, die Rückseite des Anzeigefelds an der ersten Platte des Wärmeableitungsmoduls zu befestigen.

## Revendications

1. Module de dissipation de chaleur (240) comprenant :
une première plaque (UL) ;
une paroi de séparation (PW) couplée à la première plaque (UL) et définissant un premier chemin (PT1) comportant un côté fermé par la première plaque (UL), et un second chemin (PT2) espacé du premier chemin (PT1) et communiquant avec l'extérieur du module de dissipation de chaleur (240), le premier chemin (PT1) formant une boucle fermée ;
un fluide de travail (FL, WZ) disposé dans le premier chemin (PT1) ; et
une seconde plaque (LL) couplée à la paroi de séparation (PW), la paroi de séparation (PW) étant disposée entre la première plaque (UL) et la seconde plaque (LL), ledit second chemin (PT2) étant disposé entre la paroi de séparation (PW) et la seconde plaque (LL),
**caractérisé en ce que**
la seconde plaque (LL) comprend au moins un trou (HOLE) qui expose au moins une partie du second chemin (PT2).

2. Module de dissipation de chaleur selon la revendication 1,
ladite paroi de séparation étant disposée de manière à être inclinée par rapport au plan de la première plaque et au plan de la seconde plaque,
ladite largeur du premier chemin se rétrécissant à partir de la première plaque jusqu'à la seconde plaque et ladite largeur du second chemin se rétrécissant à partir de la seconde plaque jusqu'à la première plaque.

3. Module de dissipation de chaleur selon la revendication 1,
ladite paroi de séparation comprenant au moins une partie étagée,
ladite largeur du premier chemin dans chacune des parties étagées diminuant à partir de la première plaque (UL) jusqu'à la seconde plaque (LL) ; et
ladite largeur du second chemin dans chacune des parties étagées diminuant à partir de la seconde plaque (LL) jusqu'à la première plaque (UL).

4. Module de dissipation de chaleur selon l'une quelconque des revendications précédentes, ladite paroi de séparation (PW) comprenant une ouverture (OPN) dans une zone opposée à la première plaque et ledit second chemin communiquant avec l'extérieur du module de dissipation de chaleur par l'intermédiaire de l'ouverture.

5. Module de dissipation de chaleur selon la revendication 1, ledit premier chemin étant plus large que le second chemin.

6. Module de dissipation de chaleur selon l'une quelconque des revendications précédentes, ledit fluide de travail comprenant un liquide et une couche d'air.

7. Module de dissipation de chaleur selon la revendication 6, le volume du liquide dans le fluide de travail étant supérieur ou égal à 20 % et inférieur à 100 %.

8. Dispositif électronique (100) comprenant :
un panneau d'affichage (210) comprenant une pluralité de pixels (PX) agencés pour afficher une image sur une surface avant du panneau d'affichage ; et
un module de dissipation de chaleur (240) selon l'une quelconque des revendications précédentes, disposé sur une surface arrière du panneau d'affichage.

9. Dispositif électronique selon la revendication 8, comprenant en outre un composant adhésif (TP) fixé à la surface arrière du panneau d'affichage et conçu pour fixer la surface arrière du panneau d'affichage à la première plaque du module de dissipation de chaleur.
